# EUROPÄISCHE PATENTSCHRIFT

(11) **EP 0 886 304 B1**
(45) Veröffentlichungstag und Bekanntmachung des Hinweises auf die Patenterteilung: **12.12.2001**
(21) Anmeldenummer: 98890157.5
(22) Anmeldetag: 22.05.1998
(51) Int. Cl.: H01L 21/00

(54) **Greifer für scheibenförmige Gegenstände**
Gripper for disc substrates
Manipulateur de substrats discoides

(30) Priorität: 18.06.1997 AT 106197
(43) Veröffentlichungstag der Anmeldung: 23.12.1998
(73) Patentinhaber: SEZ Semiconductor-Equipment Zubehör für die Halbleiterfertigung AG, 9500 Villach (AT)
(72) Erfinder: Pirker, Willibald, 9530 Bad Bleiberg (AT)
(74) Vertreter: Beer, Manfred, Dipl.-Ing.

(56) Entgegenhaltungen:
- WO-A-95/11518
- US-A- 4 453 757

## Beschreibung

Die Erfindung betrifft einen Greifer für scheibenförmige Gegenstände mit den Merkmalen des einleitenden Teils von Anspruch 1.

Ein derartiger Greifer ist aus der WO 95/11518 A bekannt. Bei dem bekannten Greifer werden die Greifklauen in der den scheibenförmigen Gegenstand (Wafer) haltenden Stellung durch Federkraft gehalten, so daß die Lage des scheibenförmigen Gegenstandes (Wafer) gegenüber dem Greifer nicht eindeutig definiert ist, weil der konische Spreizkörper bei dem bekannten Greifer auf die Greifklauen nicht mehr einwirkt, sobald vom Greifer ein scheibenförmiger Gegenstand gehalten wird, also die Greifklauen am Außenrand des Gegenstandes anliegen. Häufig wurden scheibenförmige Gegenstände (Wafer) nicht zentrisch zur Greiferachse gehalten. Dies insbesondere, wenn eine Abflachung (flat) oder eine Einkerbung (notch) am Rand des scheibenförmigen Gegenstandes (Wafer) im Bereich einer der Greifklauen zu liegen kommt. In einem solchen Fall kann diese Greifklaue auf den scheibenförmigen Gegenstand keine radial nach innen wirkende Kraft ausüben, so daß die ihr gegenüberliegende Greifklaue unter der Wirkung der sie belastenden Federkraft den scheibenförmigen Gegenstand aus der zentrischen Lage verschiebt. Auch für den Fall, daß alle Greifklauen am Rand des scheibenförmigen Gegenstandes anliegen, wenn ein solcher mit dem bekannten Greifer gehalten wird, ergeben sich unterschiedliche Haltepositionen, da die Federkonstanten der einzelnen die Greifklauen nach innen belastenden Federn nicht genau gleich groß sind.

Durch die oben beschriebene Problematik ergeben sich beim Auflegen von scheibenförmigen Gegenständen auf Halterungen, z.B. beim Auflegen von Silizium-Wafer auf Träger (chucks), welche die Gegenstände während weiterer Behandlungsschritte (Ätzen, Polieren u. dgl.) halten, Probleme insoferne, als der bekannte Greifer den scheibenförmigen Gegenstand nur in Ausnahmefällen, also eher zufällig, genau konzentrisch zur Drehachse des Trägers ablegen konnte. Dies stellt bei Trägern, die auf ihrer dem scheibenförmigen Gegenstand zugekehrten Fläche mit (verstellbaren) Stiften ausgestattet sind, welche sich gegebenenfalls radial nach innen bewegen können, um den scheibenförmigen Gegenstand zu zentrieren (US-A-5 513 668), kein Problem dar, da der scheibenförmige Gegenstand schlußendlich doch zentriert war. Bei Trägern für scheibenförmige Gegenstände ohne die oben erwähnten Zapfen, bei welchen die scheibenförmigen Gegenstände ausschließlich oder vornehmlich durch das Bernoulli-Prinzip (US-A-4 903 717) oder durch Unterdruck (WO 97/03457) festgehalten werden, ergeben sich bei nicht konzentrisch abgelegten, scheibenförmigen Gegenständen Probleme mit der Unwucht, wenn der scheibenförmige Gegenstand vom Träger während der vorzunehmenden Behandlungsschritte in Drehung versetzt wurde.

Die US-A- 4 453 757 offenbart einen Greifer für Halbleiterwafer, mit einem Grundkörper, mit relativ zum Grundkörper verstellbaren Greifklauen, mit elastischen Mitteln, welche die Greifklauen auf den Grundkörper zu belasten, und mit einer Spreizeinrichtung, mit deren Hilfe die Greifklauen entgegen der Wirkung der elastischen Mittel nach außen verstellbar sind. Außerdem ist den Greifklauen eine Führungsrille zugeordnet, die das Verschieben einzelner Greifklauen weiter nach innen als jede andere der Greifklauen verhindert, bis sich die die Greifklauen tragenden Stäbe im tiefsten Bereich der Führungsrille befindet. Die Führungsrille ist außerdem in Anlage an mit den Greifklauen verbundenen Bauteilen gehalten. Bei dem Greifer der US-A-4 453 757 liegen die mit den Greifklauen verbundenen Bauteile nicht am Boden der Führungsrillen an, wenn der Greifer einen Halbleiterwafer hält (vgl. Fig. 4 "ΔS" der US-A 4 453 757).

Der Erfindung liegt die Aufgabe zugrunde, die Konstruktion des bekannten Greifers so zu ändern, daß sich einzelne Greifklauen nicht unabhängig von anderen Greifklauen radial nach innen bewegen können.

Gelöst wird diese Aufgabe mit den Merkmalen des kennzeichnenden Teils von Anspruch 1.

Bevorzugte und vorteilhafte Ausgestaltungen des erfindungsgemäßen Greifers sind Gegenstand der Unteransprüche.

Da bei dem erfindungsgemäßen Greifer durch den Anschlag Vorsorge getroffen ist, daß sich keine der Greifklauen radial weiter nach innen verschieben kann als andere Greifklauen (in der Regel sind beispielsweise sechs Greifklauen vorgesehen), werden scheibenförmige Gegenstände stets konzentrisch zur Achse des Greifers und in reproduzierbarer (definierter) Lage gehalten und können vom Greifer auf einen Träger für scheibenförmige Gegenstände definiert, beispielsweise konzentrisch zur Achse des Trägers aufgelegt werden können.

Der Anschlag, der dafür sorgt, daß die Greifklauen nur gemeinsam radial verschoben werden können, kann, wie im Rahmen der Erfindung bevorzugt, die bei dem bekannten Greifer (WO 95/11518 A) vorgesehene Spreizeinrichtung, die beispielsweise und bevorzugt ein konischer Spreizkörper ist, der mit den radial inneren Enden der Führungsstäbe oder der Führungskörper der Greifklauen zusammenwirkt, sein. Damit der Anschlag ständig an den inneren Enden der Führungsstäbe oder Führungskörper der Greifklauen anliegt, ist vorgesehen, daß dem Spreizkörper eine Feder zugeordnet ist, die ihn ständig in Anlage an die Führungsstäbe oder Führungskörper der Greifklauen bzw. an diesen vorgesehenen Rollen hält. Der Anschlag, der in einer Ausführungsform der Spreizkörper ist, der dazu dient, die Greifklauen beim Öffnen des Greifers (radial) nach außen zu verschieben, verhindert so durch seine Anlage an (radial) innen liegenden Teilen der Greifklauen (Führungsstangen, Führungskörper oder an diesem vorgesehene Rollen), daß sich die Greifklauen voneinander unabhängig bewegen können. Die Greifklauen können sich nur gemeinsam bewegen. Wenn eine der Greifklauen, aus welchem Grund immer, mit größerer Kraft auf den in einer Ausführungsform konischen Anschlag einwirkt als die anderen Greifklauen, wird der Anschlag nach oben bewegt und die anderen Greifklauen bewegen sich wegen der auf sie einwirkenden Federkraft nach innen und bleiben ebenfalls in Anlage am Anschlag. Es ist somit bei der erfindungsgemäßen Konstruktion des Greifers nicht möglich, daß sich einzelne Greifklauen unabhängig von den anderen radial nach innen bewegen.

Weitere Einzelheiten und Vorteile der Erfindung ergeben sich aus der nachstehenden Beschreibung eines bevorzugten Ausführungsbeispieles der Erfindung, in der auf die angeschlossene Zeichnung Bezug genommen wird. Es zeigt:
Fig. 1 einen Greifer im Achsialschnitt, wobei auf der linken Hälfte der Fig. 1 die Greifklaue radial nach innen verschoben ist, wogegen die in Fig. 1 rechts gezeigte Greifklaue von der Spreizeinrichtung radial nach außen verschoben ist, und
Fig. 2 eine Draufsicht auf den Greifer (bei abgenommenen Gehäusedekkel).

Der erfindungsgemäße Greifer besteht aus einem Grundkörper 1, der im gezeigten Ausführungsbeispiel eine kreisrunde Umrißform hat, und aus, im gezeigten Ausführungsbeispiel sechs, relativ zum Grundkörper 1 radial nach innen und nach außen verschiebbaren Greifklauen 2.

Der Grundkörper 1 besitzt eine im wesentlichen zylinderförmige Wand 3, einen Deckel 4 und eine Basisplatte 5. Die genannten Bauteile des Grundkörpers 1 sind durch Schrauben 6 miteinander verbunden. Die Basisplatte 5 kann auch mit der Wand 3 einstückig ausgeführt sein.

In der Wand 3 des Grundkörpers 1 sind Führungsbuchsen 7 eingesetzt, in welchen radial ausgerichtete Führungsstäbe 8 der Greifklauen 2 verschiebbar geführt sind. An den äußeren Enden der Führungsstäbe 8 sind Haltestücke 9 vorgesehen, an welchen Stifte 10 mit einem vorspringenden Flansch 11 vorgesehen sind. Die Stifte 10 sind die zum Ergreifen eines scheibenförmigen Gegenstandes wirksamen Teile der Greifklauen 2. Die außerhalb der Wand 3 liegenden Teile der Führungsstäbe 8 können durch längenveränderliche Faltenbälge (nicht dargestellt) abgedeckt sein.

Die Stifte 10 können oberhalb des Flansches 11 einen von zwei Konusflächen begrenzten Ring aufweisen. Insbesonders bei dieser, in Fig. 3 der WO 95/11518 gezeigten Ausführungsform können die noch zu beschreibenden Ansätze 30 an den Haltestücken 9 auch entfallen.

An den Haltekörpern 9 für die Stifte 10 können radial nach innen weisende, zungenartige Ansätze 30 vorgesehen sein. Diese Ansätze 30, genauer die an ihnen angebrachten knopfartigen Auflagen, dienen als Auflage für einen scheibenförmigen Gegenstand, wenn die Basisplatte 5 des Grundkörpers 1 durch Verdrehen des Grundkörpers 1 nach oben weist.

An den radial inneren Enden der Führungsstäbe 8 sind Führungskörper 12 befestigt, die in Führungsnuten 13 radial verschiebbar sind. Die Führungsnuten 13 für die Führungskörper 12 werden von je zwei annähernd radial verlaufenden Wänden 15 und 16 gebildet, die an der Basisplatte 5 des Grundkörpers 1 nach innen vorstehend, angeformt sind.

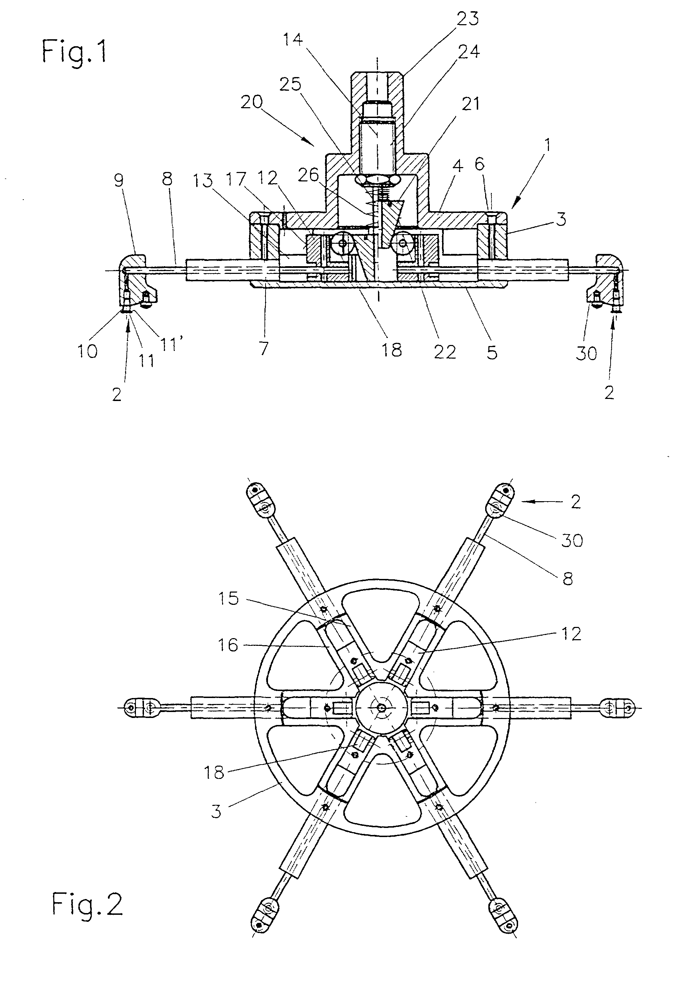

Um die Greifklauen 2 aus der in Fig. 1 links gezeigten Bereitschaftsstellung, in die sie durch nicht gezeigte Federn (z.B. über die Führungsstäbe 8 gesetzte Schraubendruckfedern oder eine ringförmige Schraubenfeder oder ein gummielastisches Band, das um die Außenflächen 17 der Führungskörper 12 gelegt ist) gedrückt werden, radial nach außen zu drücken, ist eine Spreizeinrichtung 20 vorgesehen.

Das erwähnte Federmittel, das die Greifklauen 2 radial nach innen belastet, können auch pneumatische Federn sein, die so wirken, daß sie die Greifklauen radial nach innen belasten.

Die Spreizeinrichtung 20 besteht im gezeigten Ausführungsbeispiel aus einem Spreizkörper 21 mit konischer Mantelfläche 22, die über an den Führungskörpern 12 frei drehbar gelagerte Rollen 18 auf die Führungskörper 12 und damit über die Führungsstäbe 8 auf die Greifklauen 2 einwirkt. Zum Betätigen des Spreizkörpers 21 ist in einem Ansatz des Deckelteils 4 des Grundkörpers 1 ein Druckmittelmotor 24, vorzugsweise ein Pneumatikzylinder, aufgenommen, dessen Kolbenstange 25 mit dem Spreizkörper 21 verbunden ist.

Wenn mit dem erfindungsgemäßen Greifer ein auf einer Fläche liegender, scheibenförmiger Gegenstand, z.B. ein Silizium-Wafer aufgenommen werden soll, wird zunächst der Pneumatikzylinder 24 betätigt, um den Spreizkörper 21 nach unten bis in Anlage an die Innenseite der Basisplatte 5 zu verstellen (linke Seite der Figur 1). Jetzt befinden sich die Greifklauen 2 in ihrer radial äußersten Stellung. Nun wird der Greifer von Hand aus oder über einen Bewegungsautomaten (Roboter) in eine Stellung bewegt, in der sich die Stifte 10 an den Greifklauen 2 neben den Außenumfang des aufzunehmenden Gegenstandes befinden. Sobald dies geschehen ist, wird der Spreizkörper 21 nach oben bewegt, so daß die Stifte 10 in Anlage an den Außenumfang des scheibenförmigen Gegenstandes gelangen.

Das Ergreifen erfolgt auch zuverlässig, wenn der Gegenstand auf einer Unterlage flächig aufliegt, da die Flansche 11 an den freien Enden der Greifstifte 10 schräg nach oben weisende (konusmantelförmige), obere Begrenzungsflächen 11' aufweisen. Beim Bewegen der Stifte 10 nach innen wird der scheibenförmige Gegenstand angehoben, da er über die Schrägflächen 11' nach oben gleitet, bis die Stifte 10 am Außenumfang des Gegenstandes anliegen.

Wenn es sich bei dem scheibenförmigen Gegenstand, wie dies bei Silizium-Wafers der Fall ist, um einen nicht exakt kreisrunden Gegenstand handelt, dann werden einige der Greifklauen 2 nicht am Außenumfang des Gegenstandes anliegen.

Bei dem erfindungsgemäßen Greifer ist die Spreizeinrichtung 20 unabhängig davon, welche Ausführungsform sie besitzt, so ausgeführt, daß sie nicht nur dazu dient die Greifklauen 2 (radial) nach außen zu bewegen, bevor ein scheibenförmiger Gegenstand aufgenommen wird, sondern sie dient auch dazu zu verhindern, daß sich einzelne Greifklauen 2, wie dies bei dem aus der WO 95/11518 bekannten Greifer an sich möglich ist, (radial) weiter nach innen bewegen als andere Greifklauen 2.

Dies wird dadurch erreicht, daß dem Spreizkörper 21 der Spreizeinrichtung 20 nicht nur der Druckmittelmotor 24, sondern auch eine Feder 26 zugeordnet ist. Die Feder 26 hält auch bei drucklosem Druckmittelmotor 24 den Spreizkörper 21 weiterhin in Anlage an die Greifklauen 2. Dabei ist es gleichgültig, ob der Spreizkörper 21, wie im gezeigten Ausführungsbeispiel, an den Rollen 18 der Greifklauen 2, an den Führungskörpern 12 der Führungsstäbe 8, an den Führungsstäben 8 oder an beliebigen anderen mit den Greifklauen 2 verbundenen Bauteilen anliegt.

Die Feder 26, die den Spreizkörper 21 belastet, kann, wie im Ausführungsbeispiel gezeigt, eine Druckschraubenfeder sein. Es ist aber auch möglich, eine andere Feder, z.B. eine pneumatische Feder vorzusehen, die den Spreizkörper 21 in Anlage an die Greifklauen 2 oder mit ihnen verbundene Bauteile, z.B. die Rollen 18, hält. Es ist auch eine Ausführungsform denkbar, bei welcher der Druckmittelmotor 24, der z.B. ein Pneumatikzylinder ist, der den Spreizkörper 21 betätigt, als pneumatische Feder herangezogen wird, indem er mit entsprechend geringem Druck beaufschlagt wird.

Wesentlich ist, daß die Federkraft, die auf den Spreizkörper 21 einwirkt, um diesen in Anlage an die Greifklauen 2 oder mit ihnen verbundene Bauteile zu halten, nicht so groß ist, daß von der dem Spreizkörper 21 zugeordneten Feder 26 auf die Greifklauen 2 so große Kräfte ausgeübt werden, daß die Greifklauen 2 unter der Wirkung der ihnen zugeordneten und sie radial nach innen belastenden Federn nicht mehr nach innen verstellt werden, da sonst ein sicheres Erfassen eines scheibenförmigen Gegenstandes mit dem Greifer nicht mehr möglich wäre.

Durch die erfindungsgemäße Ausbildung des Greifers, bei dem die Greifklauen 2 - im gezeigten Ausführungsbeispiel durch die ihnen zugeordnete Spreizeinrichtung 20 mit dem konischen Spreizkörper 21 - miteinander gekuppelt sind, so daß sich einzelne Greifklauen 2 nicht weiter (radial) nach innen bewegen können, als andere Greifklauen 2, wird sichergestellt, daß ein scheibenförmiger Gegenstand stets in definierbarer, reproduzierbarer Lage zum Greifer, insbesondere konzentrisch zur Achse 14 des Greifers, gehalten wird, selbst wenn der scheibenförmige Gegenstand eine von der exakten Kreisform abweichende Umrißform aufweist.

Zusammenfassend kann ein bevorzugtes Ausführungsbeispiel der Erfindung wie folgt beschrieben werden:

Ein Greifer für scheibenförmige Gegenstände (Silizium-Wafer) besitzt mehrere radial verstellbare Greifklauen 2. Die Greifklauen 2 werden von Federn belastet, so daß sie beim Halten eines Gegenstandes an dessen Außenrand anliegen.

Um die Greifklauen 2 nach außen zu verstellen, ist eine Spreizeinrichtung 20 mit einem konischen Spreizkörper 21 vorgesehen. Zusätzlich sind die Greifklauen 2 so miteinander gekuppelt, daß sie sich nicht unabhängig voneinander nach innen bewegen können und sichergestellt ist, daß sich einzelne der Greifklauen 2 nicht weiter nach innen bewegen können als andere Greifklauen 2. Dies wird dadurch erreicht, daß der konische Spreizkörper 21 durch eine Feder 26 belastet wird, die ihn ständig in Anlage an mit den Greifklauen 2 verbundenen Bauteilen, beispielsweise an ihren Führungskörpern 12 vorgesehenen Rollen 18 hält. Dadurch ist zuverlässig verhindert, daß sich einzelne Greifklauen 2 radial weiter nach innen bewegen als andere Greifklauen 2. So wird der Gegenstand vom Greifer in definierter Lage zum Greifer gehalten.

## Patentansprüche

1. Greifer für Halbleiterwafer und andere scheibenförmige Gegenstände mit wenigstens annähernd kreisrundem Außenumfang, mit einem Grundkörper (1), mit relativ zum Grundkörper (1) verstellbaren Greifklauen (2), mit elastischen Mitteln, welche die Greifklauen (2) auf den Grundkörper (1) zu belasten, und mit einer Spreizeinrichtung (20), mit deren Hilfe die Greifklauen (2) entgegen der Wirkung der elastischen Mittel nach außen verstellbar sind, wobei den Greifklauen (2) ein Anschlag (21) zugeordnet ist, der das Verschieben einzelner Greifklauen (2) weiter nach innen als jede andere der Greifklauen (2) verhindert, **dadurch gekennzeichnet, daß** der Anschlag (21) durch eine Feder (26) in Anlage an mit den Greifklauen (2) verbundenen Bauteilen (8, 12, 18) gehalten ist.

2. Greifer nach Anspruch 1, **dadurch gekennzeichnet, daß** der Anschlag ein konischer Körper (21) ist.

3. Greifer nach Anspruch 2, **dadurch gekennzeichnet, daß** der Körper (21) durch die Feder (26) in Anlage an Rollen (18) an Führungskörpern (12) für Führungsstäbe (8) der Greifklauen (2) gehalten ist.

4. Greifer nach einem der Ansprüche 1 bis 3 **dadurch gekennzeichnet, daß** der Anschlag ein konischer Spreizkörper (21) der den Greifklauen (2) zugeordneten Spreizeinrichtung (20) ist.

5. Greifer nach einem der Ansprüche 1 bis 4, **dadurch gekennzeichnet, daß** die Feder eine Druckschraubenfeder (26) ist.

6. Greifer nach einem der Ansprüche 1 bis 4, **dadurch gekennzeichnet, daß** die Feder eine pneumatische Feder ist.

7. Greifer nach Anspruch 6, **dadurch gekennzeichnet, daß** die pneumatische Feder der Antriebszylinder (24) für den Spreizkörper (21) der Spreizeinrichtung (20) ist.

8. Greifer nach einem der Ansprüche 2 bis 7, **dadurch gekennzeichnet, daß** die von der den konischen Körper (21) belastenden Feder (26) auf die Greifklauen (2) ausgeübte, in Richtung der Bewegung der Greifklauen (2) wirkende Kraftkomponente kleiner ist als die Kräfte, die von den elastischen Mitteln, welche die Greifklauen (2) radial nach innen belasten, auf die Greifklauen (2) ausgeübt werden.

## Claims

1. Gripper for semiconductor wafers and other disc-shaped objects, having at least a virtually circular external circumference, having a basic body (1), having gripping claws (2), which are adjustable relative to the basic body (1), having flexible means, which load the gripping claws (2) towards the basic body (1), and having an expanding device (20), by means of which the gripping claws (2) are adjustable outwardly in opposition to the effect of the flexible means, a limit stop (21) being assigned to the gripping claws (2) and preventing the displacement of individual gripping claws (2) further inwardly than any other of the gripping claws (2), **characterised in that** the limit stop (21) is retained by a spring (26) in abutment against components (8, 12, 18), which are connected to the gripping claws (2).

2. Gripper according to claim 1, **characterised in that** the limit stop is a conical body (21).

3. Gripper according to claim 1, **characterised in that** the body (21) is retained by the spring (26) in abutment against the rollers (18) on the guide bodies (12) for guide rods (8) of the gripping claws (2).

4. Gripper according to one of the claims 1 to 3, **characterised in that** the limit stop is a conical expanding body (21) of the expanding device (20) which is assigned to the gripping claws (2).

5. Gripper according to one of the claims 1 to 4, **characterised in that** the spring is a pressure screw spring (26).

6. Gripper according to one of the claims 1 to 4, **characterised in that** the spring is a pneumatic spring.

7. Gripper according to claim 6, **characterised in that** the pneumatic spring is the drive cylinder (24) for the expanding body (21) of the expanding device (20).

8. Gripper according to one of the claims 2 to 7, **characterised in that** the force component, which is exerted by the spring (26), which loads the conical body (21), on the gripping claws (2) and which operates in the direction of the movement of the gripping claws (2), is smaller than the forces which are exerted on the gripping claws (2) by the flexible means which load the gripping claws (2) radially inwardly.

## Revendications

1. Préhenseur pour plaquettes semi-conductrices et autres objets en forme de disques à contour extérieur au moins sensiblement circulaire, avec un corps de base (1), avec des griffes de préhension (2) déplaçables par rapport au corps de base (1), avec des moyens élastiques qui sollicitent les griffes de préhension (2) en direction du corps de base (1) et avec un dispositif d'écartement (20), à l'aide duquel les griffes de préhension (2) peuvent être déplacées en direction de l'extérieur, à l'encontre de la force des moyens élastiques, une butée (21), qui empêche que des griffes de préhension (2) avancent plus que d'autres griffes de préhension (2) en direction de l'intérieur, étant associée aux griffes de préhension (2), **caractérisé en ce que** la butée (21) est maintenue par un ressort (26) en appui sur des éléments (8, 12, 18) liés aux griffes de préhension (2).

2. Préhenseur selon la revendication 1, **caractérisé en ce que** la butée est un corps (21) conique.

3. Préhenseur selon la revendication 1, **caractérisé en ce que** le corps (21) est maintenu par le ressort (26) en appui sur des galets (18) montés sur des éléments de guidage (12) de tiges de guidage (8) des griffes de préhension (2).

4. Préhenseur selon une des revendications 1 à 3, **caractérisé en ce que** la butée est un corps d'écartement (21) conique du dispositif d'écartement (20) associé aux griffes de préhension (2).

5. Préhenseur selon une des revendications 1 à 4, **caractérisé en ce que** le ressort est un ressort hélicoïdal de compression (26).

6. Préhenseur selon une des revendications 1 à 4, **caractérisé en ce que** le ressort est un ressort pneumatique.

7. Préhenseur selon la revendication 6, **caractérisé en ce que** le ressort pneumatique est le vérin d'entraînement (24) du corps d'écartement (21) du dispositif d'écartement (20).

8. Préhenseur selon une des revendications 2 à 7, **caractérisé en ce que** la composante de force qui est exercée sur les griffes de préhension (2) par le ressort (26) sollicitant le corps (21) conique et agit dans la direction du déplacement des griffes de préhension (2) est inférieure aux forces exercées sur les griffes de préhension (2) par les moyens élastiques qui sollicitent les griffes de préhension (2), radialement en direction de l'intérieur.
